# EUROPEAN PATENT SPECIFICATION

(11) **EP 3 324 715 B1**
(45) Date of publication and mention of the grant of the patent: **06.05.2020**
(21) Application number: 17160329.3
(22) Date of filing: 10.03.2017
(51) Int. Cl.: H05K 7/20

(54) **COOLING ARRANGEMENT FOR A POWER SUPPLY MODULE**
KÜHLANORDNUNG FÜR EIN STROMVERSORGUNGSMODUL
AGENCEMENT DE REFROIDISSEMENT POUR UN MODULE D'ALIMENTATION ÉLECTRIQUE

(30) Priority: 16.11.2016 IL 24900516
(43) Date of publication of application: 23.05.2018
(73) Proprietor: TDK-LAMBDA LTD, 2161401 Karmiel Industrial Zone (IL)
(72) Inventor: STRAVETS, Miki, 2623196 Kiryat Motzkin (IL); RUCAREANU, George, 3681001 Nesher (IL)
(74) Representative: Lavoix

(56) References cited:
- US-A1- 2005 195 567
- US-A1- 2006 049 728
- US-A1- 2010 268 398
- US-A1- 2016 034 008

## Description

### Field of the Invention

The present invention relates to the field of power supply modules. More particularly, the invention relates to a cooling arrangement for such devices.

### Background of the Invention

Power supply modules for converting AC power to DC power are generally characterized by the presence of heat-generating components, including an inverter for converting rectified DC power to high frequency power and a transformer for lowering the voltage of the high frequency power. The lowered-voltage power is then converted into DC power by an output rectifier circuit, enabling the DC power to be applied to a load. Efficient operation of a power supply module requires dissipation of the generated heat, generally by means of cooling air that flows through the interior of the power supply module.

However, the front panel of a chassis in which the electronic components of a power supply module are housed is generally equipped with control elements for setting desired values of input and output voltage or other parameters of importance, such as switches, knobs and buttons, and with a display screen or LED indicators, thereby reducing the available area on the front panel for the provision of air flow openings.

Due to the limited number of air flow openings in the front panel, the housed electronic components many times experience unwanted heating that leads not only to a decrease in efficiency, but also to power supply malfunction.

US 2006/0049728 discloses a computer bezel that includes a computer chassis, a front bezel, an inlet airflow guiding member formed on the front bezel, an airflow guiding space defined between the front bezel and the computer chassis, and a plurality of inlet airflow openings formed on or around the inlet airflow guiding member. In one embodiment, the inlet airflow guiding member is a trapezoidal prism, and the inlet airflow openings are formed on the top plate, the bottom plate, and the side plates.

US 2016/0034008, US 2010/0268398 and US 2005/0195567 also disclose a structure for an electrical appliance that is configured with air intake openings.

A power supply module is often rack mounted. A rack is a type of frame that facilitates the stacking of electronic devices, including power supply modules, one on top of the other. For many industrial applications, a rack typically, but not necessarily, having a width of 19 inches is used for the compact stacking of a rectangular chassis that houses an electronic device. Each chassis is releasably coupled to the rack, such as by horizontal rails that are engageable with a corresponding side of the chassis, in order to be selectively extended and retracted upon demand so that maintenance or service operations may be performed.

While operating, a rack mounted power supply module becomes heated and needs to be continuously cooled. Since each chassis is stacked in close proximity to, and is generally in abutting relation with, an overlying chassis, thereby restricting or altogether preventing the passage of cooling air into the chassis from above or from below, and is coupled to the rack from the side, thereby restricting or altogether preventing the passage of cooling air into the chassis from the side, the only practical way the power modules are able to be cooled is via air flow openings formed in a front panel of the chassis. However, the available area on the front panel for the provision of air flow openings is limited, as described above.

It is an object of the present invention to provide a front panel configuration that facilitates an increased influx relative to the prior art of cooling air into a chassis within which heatable electronic components of a power supply module are housed.

Other objects and advantages of the invention will become apparent as the description proceeds.

### Summary of the Invention

The present invention provides a module for facilitating an increased flow of cooling air according to claim 1 .

According to one embodiment, the cooling air is introduced through the one or more recessed airflow openings and through the plurality of unrecessed air flow openings and exits from an opening provided at a rear region of the chassis.

In one aspect, the one or more recessed air flow openings are longitudinally spaced.

The inclined surface is of much utility when a portion thereof is in abutting relation with a corresponding portion of an additional power supply module that is vertically spaced to the power module, causing the cooling air to flow through the one or more airflow openings of both the power supply module and the additional power supply module.

In one embodiment, the additional power supply module comprises the chassis and the front panel, and both the power supply module and the additional power supply module are formed with the one or more inclined surfaces to define together the passageway through which the cooling air is flowable.

In one embodiment, the chassis is also formed with the one or more recessed airflow openings which facilitate a vertical flow of cooling air into a chassis interior, a chassis surface being formed with a groove which is in communication with the one or more airflow openings formed with the chassis so as to be recessed from said chassis surface.

In one aspect, the power supply module is rack mounted, wherein the one or more recessed airflow openings are ensured of remaining unblocked by the rack on which the power supply module is mounted or by any other device mounted onto the rack. The front panel may be formed with an additional inclined surface in horizontal cross section that extends from an additional interface of the chassis and front panel that is adjacent to a side bracket for mounting the power supply module to the rack to a forward edge of the vertically oriented front element of the front panel which is laterally spaced from said additional interface, wherein said additional inclined surface is formed with a groove which is in communication with one or more airflow openings being recessed from said additional inclined surface to facilitate sideways air inflow into the chassis interior.

The front panel may be coupled with the chassis, or may be integrally formed with the chassis.

In one aspect, the power supply module further comprises a filter element provided with the front panel to prevent infiltration of contaminants through one or more of the upwardly facing recessed airflow openings, downwardly facing recessed airflow openings, and unrecessed air flow openings.

### Brief Description of the Drawings

In the drawings:
- Fig. 1 is a perspective view from the side of a prior art front panel for a power supply module;
- Fig. 2 is a perspective view from the side of a front panel for a power supply module, according to one embodiment of the invention;
- Fig. 2A is a perspective view from the side of a front panel for a power supply module, according to another embodiment of the invention;
- Fig. 3 is a perspective view from above of a portion of a rack mountable power supply module, according to another embodiment of the invention;
- Fig. 4 is a perspective view from the bottom of a portion of the rack mountable power supply module of Fig. 3;
- Fig. 5 is a front view of the power supply module of Fig. 3;
- Fig. 6 is a side view of a portion of the power supply module of Fig. 3, shown without an L-bracket; and
- Fig. 7 is a side view of a portion of two stacked power supply modules of Fig. 6.

### Detailed Description of Preferred Embodiments

The present invention is a novel increased air influx facilitating configuration for a front panel of a chassis that houses a power supply module.

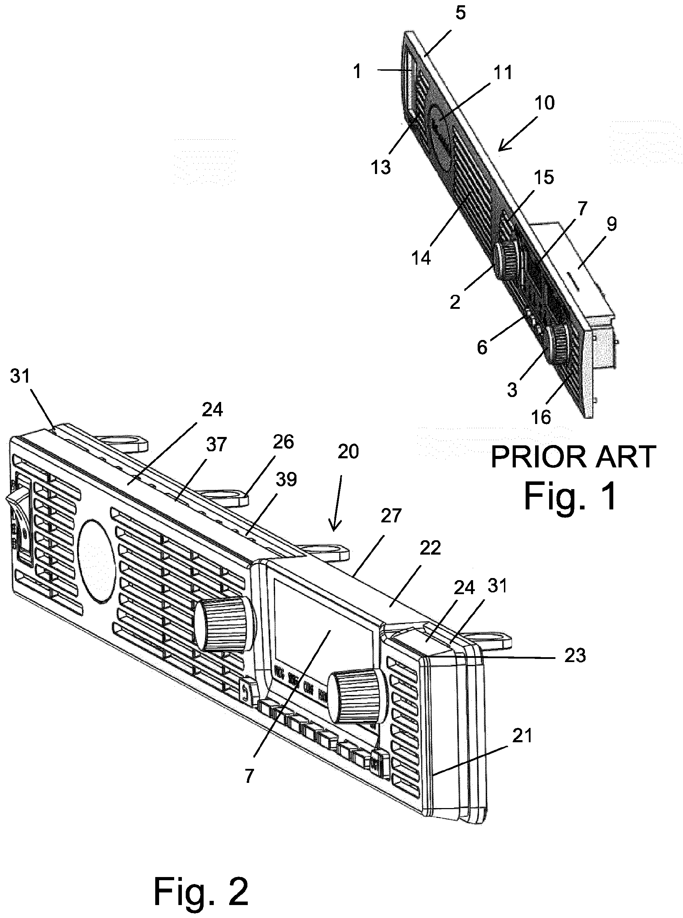

Reference is first made to Fig. 1, which illustrates a prior art front panel 10 of a power supply chassis. Prior art front panel 10 comprises a thin and rigid board 5 from which protrude a plurality of user interface elements, including switch 1, knobs 2 and 3, and buttons 6. One or more display screens 7 for viewing output information in response to a selectively manipulated user interface element are embedded within board 5 between knobs 2 and 3. When front panel 10 is fully coupled to the dedicated chassis, a circuit is closed between interface element circuitry within housing 9 at the rear of board 5 and the circuitry of the electronic device housed in the chassis, allowing the user interface elements to control operation of the power supply module.

Due to the limited surface area of board 5, the positioning of manufacturer-distinctive indicia at region 11 and the large number of user interface elements interspersed throughout the board, only four areas 13-16 of vertically spaced air flow openings are provided within board 5.

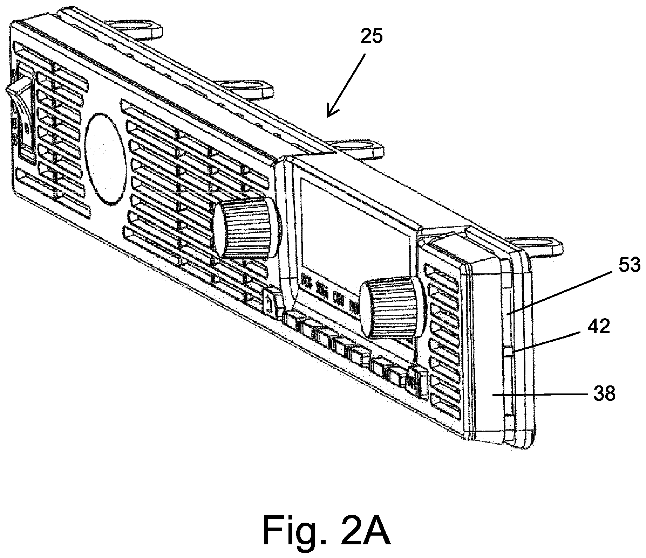

Fig. 2 illustrates a front panel 20, according to one embodiment of the invention, which is configured with additional air flow openings to enable not just horizontal air inflow, but also vertical air inflow, into the chassis interior. Front panel 20 may be coupled with a dedicated power supply chassis, such as by fasteners insertable through corresponding eyelets 26 or by other means, or alternatively may be used to retrofit an existing chassis.

To accommodate the additional air flow openings, front panel 20 is configured with different types of upper surfaces. The first type is a basic horizontal surface 22, which is perpendicular to vertically oriented display screen 7 and which may overly the interface element circuitry housing. The second upper surface type is an inclined surface 24, which extends downwardly from the rear edge 27 of basic surface 22 until coinciding with a front surface 21 of front panel 20, at an upper edge 23 thereof. Front panel 20 is shown to comprise two inclined surfaces 24 between which basic surface 22 is interposed.

A longitudinally extending groove 31, i.e. in a direction along the length or long dimension of front panel 20, is formed in a central region of each inclined surface 24 between edges 23 and 27, and may be of the same length as the corresponding inclined surface 24. A third upper surface 37 is provided below, and recessed from, the corresponding inclined surface 24, and is formed with a plurality of longitudinally spaced air flow openings 39, which may be circular apertures or of any other desired shape. Third surface 37 may be, but not necessarily, parallel to inclined surface 24, as long as the vertical projection of the opposite edges of groove 31 onto third surface 37 coincides with an opening of each air flow opening 39, in order to maximize air intake.

Front panel 20 may also be provided with three types of lower surfaces which are symmetrical to the three upper surfaces, respectively, to accommodate downwardly facing air flow openings. It will be appreciated that front panel 20 may be provided with only downwardly facing air flow openings.

When front panel 20 has both upwardly facing and downwardly facing air flow openings, the side surfaces 36 of the front panel may be trapezoidal.

As shown in Fig. 2A, a front panel 25 may have trapezoidal side surfaces 38 that are formed with one or more recessed air flow openings 42 to facilitate sideways air inflow into the chassis interior. Each side surface 38 may be configured with a vertically extending groove 53 in fluid communication with each airflow opening 42 through which cooling air is flowable.

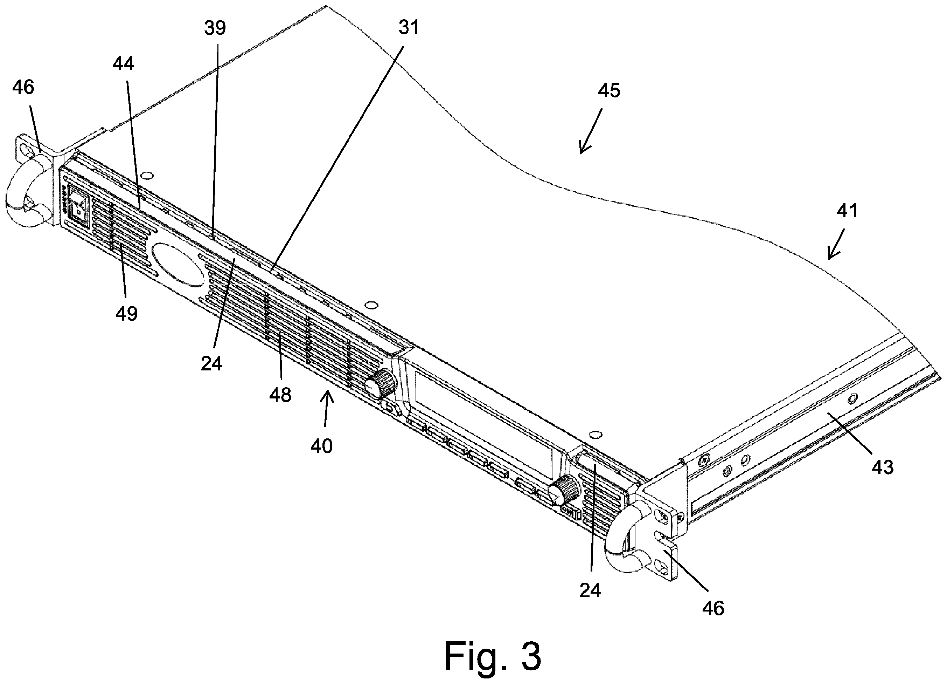

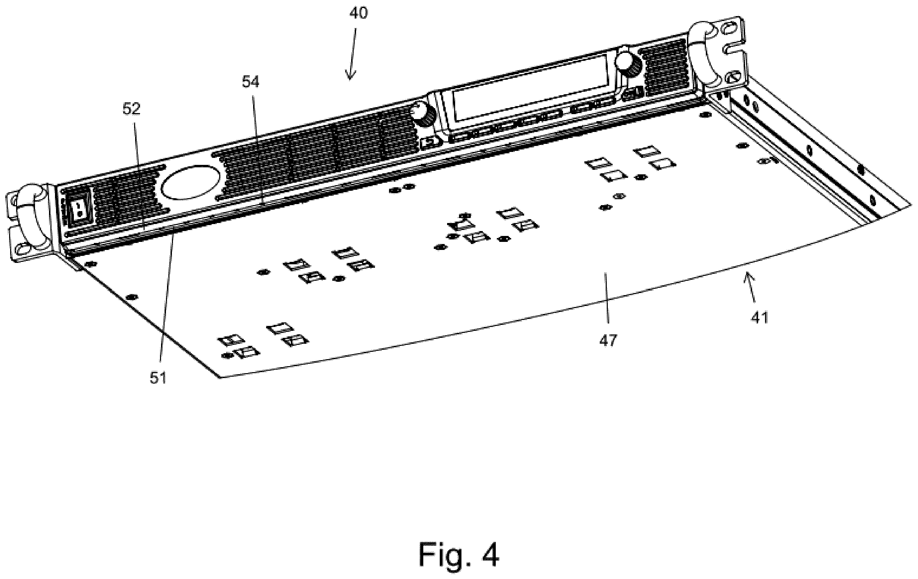

Figs. 3 and 4 illustrate a power supply module 45 comprising a chassis 41, generally but not necessarily rectangular, having a front panel 40 being configured in accordance with the present invention. Front panel 40 may be integrally formed with chassis 41, or alternatively may be formed separately from chassis 41 and coupled thereto. Each side of chassis 41 may be provided with an elongated fixture 43 for connection to a sliding mechanism or a rail, which in turn is movably connected to a rack. An L-bracket 46 or the like which is laterally adjacent to front panel 40 may be fixedly connected to a corresponding chassis side, to facilitate secured mounting onto the rack. The connection to a sliding mechanism or a rail and to an L-bracket precludes the flow of sideways intake air into chassis 41.

Front panel 40 is configured with two upper inclined surfaces 24, which may be coplanar, to accommodate the provision of longitudinally spaced and upwardly facing air flow openings 39 which are recessed therefrom and are in communication with longitudinally extending groove 31. These upwardly facing air flow openings 39 are in addition to vertically spaced air flow openings 48, which are formed in vertically oriented board 49 located below upper edge 44 thereof coinciding with an upper inclined surface 24, for providing horizontal air inflow into chassis 41. Air flow openings 48 are located below and forwardly from upwardly facing air flow openings 39.

Front panel 40 is also configured with a lower surface 52 in which is formed longitudinally extending groove 51 being in communication with downwardly facing air flow openings 54. Lower surface 52 may be inclined, for example symmetrical to an upper inclined surface 24, or alternatively may be horizontally oriented so as to be substantially parallel to the lower surface 47 of chassis 41.

A filter element (not shown) may be provided with front panel 40, to prevent the infiltration of dust or other contaminants through the air flow openings, whether upwardly facing air flow openings 39, vertically spaced air flow openings 48, downwardly facing air flow openings 54, or all of the above.

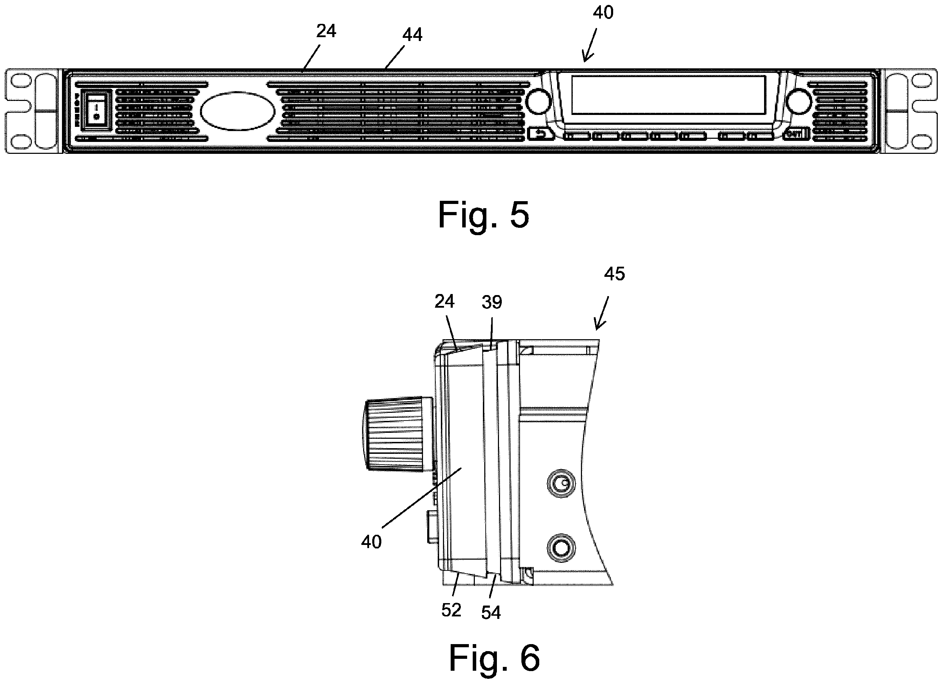

As shown in the front view of front panel 40 shown in Fig. 5, the upwardly facing air flow openings are not visible, being recessed from upper inclined surface 24 extending downwardly towards upper front board edge 44.

Fig. 6 illustrates a side view of a portion of power supply module 45 without an L-bracket. Front panel 40 is shown to have an inclined upper surface 24 and an inclined lower surface 52, making upwardly facing air flow openings 39 and downwardly facing air flow openings 54 accessible to ambient air.

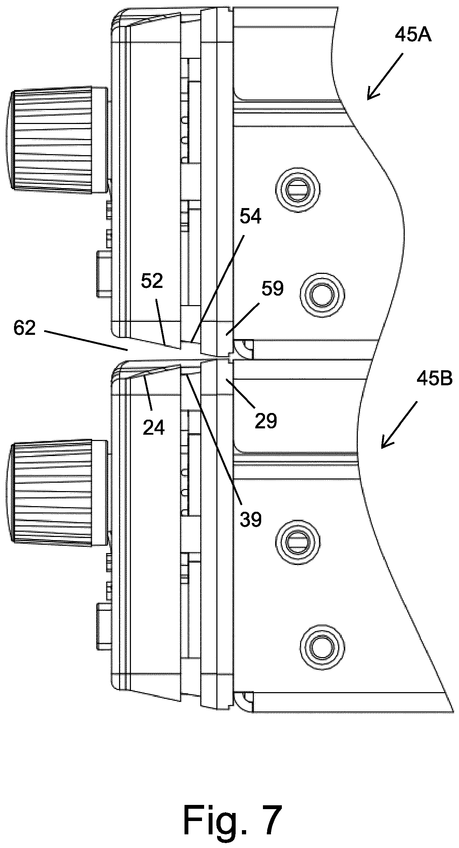

Thus when two rack-mounted power supply modules 45A-B are stacked one on top of the other as shown in Fig. 7, the ambient inflow air, after passing through passageway 62 defined by inclined upper surface 24 and an inclined lower surface 52, is blocked by abutting upper surface portion 29 and lower surface portion 59 of the front panel. This inflow air is thus urged to flow through downwardly facing air flow opening 54 of upper module 45A and upwardly facing air flow opening 39 of lower module 45B, through the chassis interior, and then through a rear chassis opening.

Although passageway 62 is shown to be defined by inclined upper surface 24 and an inclined lower surface 52, it will be appreciated that passageway 62 will also be defined when only one of upper surface 24 and an lower surface 52 is inclined.

In another embodiment of the invention, an inclined surface is formed in a side surface of the front panel to facilitate sideways air inflow. Although L-bracket 46 (Fig. 3) or the like is normally in contact with a side surface of the front panel, a chamfer-like inclined surface extending from an interface of the chassis side surface and front panel to the front surface of the front panel facilitates formation of an interspace between the bracket and the front panel. Thus when an elongated groove is formed in the chamfer-like inclined surface, airflow openings are able to be recessed and to receive sideways air inflow.

In another embodiment of the invention, the surface from which air flow openings are recessed may be formed in a dedicated surface of the chassis. This chassis surface formed with a longitudinally extending groove may be inclined at the same inclination as that of the abutting front panel surface, or at a different angle. Alternatively, the chassis surface formed with a longitudinally extending groove in communication with recessed air flow openings may be substantially horizontally oriented, as long as an opposed surface is inclined to define a passageway. A first surface of the passageway may be a part of a lower power supply module and a second surface of the passageway may be a part of an upper power supply module.

Alternatively, the surface formed with a plurality of longitudinally spaced air flow openings may be a part of the chassis while the surface in which the groove is formed may be a part of the front panel.

While some embodiments of the invention have been described by way of illustration, it will be apparent that the invention can be carried out with many modifications, variations and adaptations, and with the use of numerous equivalents or alternative solutions that are within the scope of persons skilled in the art, without exceeding the scope of the claims.

## Claims

1. A module (45, 45A, 45B) for facilitating an increased flow of cooling air, comprising a chassis (41) in which circuitry is housed, and a front panel (20, 25, 40) associated with said chassis,
wherein said module is configured with one or more airflow openings (39, 54) which facilitate a flow of cooling air into a chassis interior and which are ensured of remaining unblocked,
wherein the front panel is formed with one or more inclined surfaces (24, 52) to define at least a part of a corresponding passageway (62) through which air crossing a portion of the front panel is flowable,
**characterized in that** the module is a power supply module and the housed circuitry is circuitry of the power supply module **and in that** the one or more airflow openings are recessed airflow openings being recessed from one of the inclined surfaces, the one or more airflow openings facilitating flow of vertical inflow air into the chassis interior,
wherein each of the inclined surfaces is formed with a groove (31, 51) extending along a long dimension of the front panel and in fluid communication with the one or more recessed airflow openings through which the cooling air is flowable, the front panel further comprising an additional surface (37) in the groove which is recessed from a corresponding inclined surface and is formed with the one or more recessed airflow openings,
wherein at least one of the inclined surfaces (24, 52) in vertical cross section extends from an interface of the chassis and front panel to a vertical edge (23) of a vertically oriented front element (21) of the front panel (20, 25, 40) formed with a plurality of vertically spaced unrecessed air flow openings (48) enabling horizontal air inflow and which is vertically and laterally spaced from the interface,
wherein-
the at least one inclined surface (24) extends downwardly from the interface and the one or more recessed airflow openings (39) through which the vertical inflow air is receivable are upwardly facing; or
the at least one inclined surface (52) extends upwardly from the interface and the one or more recessed airflow openings (54) through which the vertical inflow air is receivable are downwardly facing.

2. The power supply module according to claim 1, wherein the chassis (41) is also formed with the one or more recessed airflow openings (39, 54) which facilitate a vertical flow of cooling air into a chassis interior, a chassis surface being formed with a groove which is in communication with the one or more airflow openings formed with the chassis so as to be recessed from said chassis surface.

3. The power supply module according to claim 1, wherein the one or more recessed air flow openings (39, 54) are longitudinally spaced.

4. The power supply module according to claim 1, wherein a portion thereof (59) is in abutting relation with a corresponding portion (29) of an additional power supply module (45B) that is vertically spaced thereto, causing the cooling air to flow through the one or more airflow openings (39, 54) of both the power supply module (45A) and the additional power supply module (45B).

5. The power supply module according to claim 4, wherein the additional power supply module (45B) comprises the chassis (41) and the front panel (20, 25, 40), and both the power supply module (45A) and the additional power supply module are formed with the one or more inclined surfaces (24, 52) to define together the passageway (62) through which the cooling air is flowable.

6. The power supply module according to claim 1, wherein the cooling air is introduced through the one or more recessed airflow openings (39, 54) and through the plurality of unrecessed air flow openings (48) and exits from an opening provided at a rear region of the chassis (41).

7. The power supply module according to claim 1, which is rack mounted, wherein the one or more recessed airflow openings (39, 54) are ensured of remaining unblocked by the rack on which the power supply module is mounted or by any other device (43, 46) mounted onto the rack.

8. The power supply module according to claim 7, wherein the front panel (20, 25, 40) is also formed with an additional inclined surface in horizontal cross section that extends from an additional interface of the chassis (41) and front panel that is adjacent to a side bracket (46) for mounting the power supply module to the rack to a forward edge of the vertically oriented front element (21) of the front panel which is laterally spaced from said additional interface,
wherein said additional inclined surface is formed with a groove which is in communication with one or more airflow openings being recessed from said additional inclined surface to facilitate sideways air inflow into the chassis interior.

9. The power supply module according to claim 1, wherein the front panel (20, 25, 40) is coupled with the chassis (41).

10. The power supply module according to claim 1, wherein the front panel (20, 25, 40) is integrally formed with the chassis (41).

11. The power supply module according to claim 1, wherein the additional surface (37) is elongated.

12. The power supply module according to claim 1, further comprising a filter element provided with the front panel (20, 25, 40) to prevent infiltration of contaminants through one or more of the upwardly facing recessed airflow openings (39), downwardly facing recessed airflow openings (54), and unrecessed air flow openings (48).

## Patentansprüche

1. Modul (45, 45A, 45B) zum Ermöglichen eines erhöhten Stroms von Kühlluft, umfassend einen Körper (41), in dem eine Schaltung aufgenommen ist, und eine vordere Platte (20, 25, 40), die dem Körper zugeordnet ist,
wobei das Modul mit einem oder mehreren Luftstromöffnungen (39, 54) konfiguriert ist, die einen Strom von Kühlluft in das Innere des Körpers ermöglichen, und von denen sichergestellt ist, dass die nicht blockiert bleiben,
wobei die vordere Platte mit einer oder mehreren geneigten Flächen (24, 52) gebildet ist, um mindestens einen Teil eines entsprechenden Durchgangs (62) zu definieren, durch den Luft, die einen Abschnitt der vorderen Platte quert, geströmt werden kann,
**dadurch gekennzeichnet, dass** das Modul ein Stromversorgungsmodul ist und die aufgenommene Schaltung eine Schaltung des Stromversorgungsmoduls ist, und dadurch, dass die eine oder die mehreren Luftstromöffnungen vertiefte Luftstromöffnungen sind, die von einer der geneigten Flächen vertieft sind, wobei die eine oder die mehreren Luftstromöffnungen den Strom von vertikaler Eingangsluft in das Innere des Körpers ermöglichen,
wobei jede der geneigten Flächen mit einer Nut (31, 51) gebildet ist, die sich entlang einer langen Abmessung der vorderen Platte erstreckt und in fluidischer Kommunikation mit der einen oder den mehreren vertieften Luftstromöffnungen ist, durch die die Kühlluft geströmt werden kann, wobei die vordere Platte weiter eine zusätzliche Fläche (37) in der Nut umfasst, die von einer entsprechenden geneigten Fläche vertieft ist und mit der einen oder den mehreren vertieften Luftstromöffnungen gebildet ist,
wobei sich mindestens eine der geneigten Flächen (24, 52) in vertikalem Querschnitt von einer Schnittstelle des Körpers und der vorderen Platte zu einer vertikalen Kante (23) eines vertikal ausgerichteten vorderen Elements (21) der vorderen Platte (20, 25, 40) erstreckt, die mit einer Vielzahl von vertikal beabstandeten nicht vertieften Luftstromöffnungen (48) gebildet ist, die einen horizontalen Luftstrom ermöglicht, und die vertikal und seitlich von der Schnittstelle beabstandet ist,
wobei
sich die mindestens eine geneigte Fläche (24) nach unten von der Schnittstelle erstreckt und die eine oder die mehreren vertieften Luftstromöffnungen (39), durch die die vertikale Eingangsluft erhalten werden kann, nach oben zeigen;
oder sich die mindestens eine geneigte Fläche (52) nach oben von der Schnittstelle erstreckt und die oder die mehreren vertieften Luftstromöffnungen (54), durch die die vertikale Eingangsluft erhalten werden kann, nach unten zeigen.

2. Stromversorgungsmodul (2) nach Anspruch 1, wobei der Körper (41) auch mit der einen oder den mehreren vertieften Luftstromöffnungen (39, 54) gebildet ist, die einen vertikalen Strom von Kühlluft in ein Körperinneres ermöglichen, wobei eine Körperfläche mit einer Nut gebildet ist, die mit der einen oder den mehreren Luftstromöffnungen in Kommunikation ist, die mit dem Körper gebildet sind, um von der Körperfläche vertieft zu sein.

3. Stromversorgungsmodul nach Anspruch 1, wobei die eine oder die mehreren vertieften Luftstromöffnungen (39, 54) der Länge nach beabstandet sind.

4. Stromversorgungsmodul nach Anspruch 1, wobei ein Abschnitt davon (59) in einem anstoßenden Bezug mit einem entsprechenden Abschnitt (29) eines zusätzlichen Stromversorgungsmoduls (45B) ist, das vertikal dazu beabstandet ist, wodurch verursacht wird, dass die Kühlluft durch das eine oder die mehreren Luftstromöffnungen (39, 54) sowohl des Stromversorgungsmoduls (45A) als auch des zusätzlichen Stromversorgungsmoduls (45B) strömt.

5. Stromversorgungsmodul nach Anspruch 4, wobei das zusätzliche Stromversorgungsmodul (45B) den Körper (41) und die vordere Platte (20, 25, 40) umfasst und sowohl das Stromversorgungsmodul (45A) als auch das zusätzliche Stromversorgungsmodul (45B) mit der einen oder den mehreren geneigten Flächen (24, 52) gebildet ist, um zusammen den Durchgang (62) zu definieren, durch den die Kühlluft geströmt werden kann.

6. Stromversorgungsmodul nach Anspruch 1, wobei die Kühlluft durch das eine oder die mehreren vertieften Luftstromöffnungen (39, 54) und durch die Vielzahl von nicht vertieften Luftstromöffnungen (48) eingeführt wird und aus einer Öffnung austritt, die an einem hinteren Bereich des Körpers (41) bereitgestellt ist.

7. Stromversorgungsmodul nach Anspruch 1, das Rack-montiert ist, wobei die eine oder die mehreren vertieften Luftstromöffnungen (39, 54) dagegen gesichert sind, durch das Rack, auf dem das Stromversorgungsmodul montiert ist, oder durch eine andere Vorrichtung (43, 46), die auf dem Rack montiert ist, nicht blockiert zu bleiben.

8. Stromversorgungsmodul nach Anspruch 7, wobei die vordere Platte (20, 25, 40) auch mit einer zusätzlichen geneigten Fläche in horizontalem Querschnitt gebildet ist, der sich von einer zusätzlichen Schnittstelle des Körpers (41) und der vorderen Platte erstreckt, die einer Seitenklammer (46) benachbart ist, um das Stromversorgungsmodul auf das Rack auf eine vordere Kante des vertikal ausgerichteten vorderen Elements (21) der vorderen Platte zu montieren, die seitlich von der zusätzlichen Schnittstelle beabstandet ist,
wobei die zusätzliche geneigte Fläche mit einer Nut gebildet ist, die mit einer oder mehreren Luftstromöffnungen in Kommunikation ist, die von der zusätzlichen geneigten Fläche vertieft ist, um seitlich Eingangsluft in das Köperinnere zu ermöglichen.

9. Stromversorgungsmodul nach Anspruch 1, wobei die vordere Platte (20, 25, 40) mit dem Körper (41) gekoppelt ist.

10. Stromversorgungsmodul nach Anspruch 1, wobei die vordere Platte (20, 25, 40) integral mit dem Körper (41) gebildet ist.

11. Stromversorgungsmodul nach Anspruch 1, wobei die zusätzliche Fläche (37) verlängert ist.

12. Stromversorungsmodul nach Anspruch 1, weiter umfassend ein Filterelement, das mit der vorderen Platte (20, 25, 40) bereitgestellt ist, um die Filtrierung von Verschmutzungen durch eines oder mehrere der nach oben zeigenden vertieften Luftstromöffnungen (39), nach unten zeigenden vertieften Luftstromöffnungen (54) und nicht vertieften Luftstromöffnungen (48) zu verhindern.

## Revendications

1. Module (45, 45A, 45B) pour faciliter un écoulement accru d'air de refroidissement, comprenant un châssis (41) dans lequel des circuits sont logés, et un panneau avant (20, 25, 40) associé avec ledit châssis,
dans lequel ledit module est configuré avec une ou plusieurs ouvertures d'écoulement d'air (39, 54) qui facilitent un écoulement d'air de refroidissement dans un intérieur de châssis et qui sont assurées de demeurer non bloquées,
dans lequel le panneau avant est formé avec une ou plusieurs surfaces inclinées (24, 52) afin de définir au moins une partie d'une voie de passage (62) correspondante à travers laquelle l'air traversant une partie du panneau avant peut s'écouler,
**caractérisé en ce que** le module est un module d'alimentation électrique et les circuits logés sont des circuits du module d'alimentation électrique et **en ce que** les une ou plusieurs ouvertures d'écoulement d'air sont des ouvertures d'écoulement d'air enfoncées qui sont enfoncées par rapport à l'une des surfaces inclinées, les une ou plusieurs ouvertures d'écoulement d'air facilitant l'écoulement de l'air d'entrée vertical dans l'intérieur du châssis,
dans lequel chacune des surfaces inclinées est formée avec une rainure (31, 51) s'étendant le long d'une dimension longue du panneau avant et en communication de fluide avec les une ou plusieurs ouvertures d'écoulement d'air enfoncées à travers lesquelles l'air de refroidissement peut s'écouler, le panneau avant comprenant en outre une surface supplémentaire (37) dans la rainure qui est enfoncée par rapport à une surface inclinée correspondante, et est formé avec les une ou plusieurs ouvertures d'écoulement d'air enfoncées,
dans lequel au moins l'une des surfaces inclinées (24, 52) dans la section transversale verticale s'étend à partir d'une interface du châssis et du panneau avant jusqu'à un bord vertical (23) d'un élément avant orienté verticalement (21) du panneau avant (20, 25, 40) formé avec une pluralité d'ouvertures d'écoulement d'air non enfoncées espacées verticalement (48) permettant l'entrée d'air horizontale et qui est verticalement et latéralement espacée de l'interface,
dans lequel :
la au moins une surface inclinée (24) s'étend vers le bas à partir de l'interface et les une ou plusieurs ouvertures d'écoulement d'air enfoncées (39) à travers lesquelles l'air d'entrée vertical peut être reçu, sont orientées vers le haut ; ou bien
la au moins une surface inclinée (52) s'étend vers le haut à partir de l'interface et les une ou plusieurs ouvertures d'écoulement d'air enfoncées (54) à travers lesquelles l'air d'entrée vertical peut être reçu, sont orientées vers le bas.

2. Module d'alimentation électrique selon la revendication 1, dans lequel le châssis (41) est également formé avec les une ou plusieurs ouvertures d'écoulement d'air enfoncées (39, 54) qui facilitent un écoulement vertical d'air de refroidissement dans un intérieur de châssis, une surface de châssis étant formée avec une rainure qui est en communication avec les une ou plusieurs ouvertures d'écoulement d'air formées avec le châssis afin d'être enfoncées par rapport à ladite surface de châssis.

3. Module d'alimentation électrique selon la revendication 1, dans lequel les une ou plusieurs ouvertures d'écoulement d'air enfoncées (39, 54) sont longitudinalement espacées.

4. Module d'alimentation électrique selon la revendication 1, dans lequel l'une de ses parties (59) est en relation de butée avec une partie (29) correspondant d'un module d'alimentation électrique (45B) supplémentaire qui est verticalement espacé de cette dernière, amenant l'air de refroidissement à s'écouler à travers les une ou plusieurs ouvertures d'écoulement d'air (39, 54) à la fois du module d'alimentation électrique (45A) et du module d'alimentation électrique (45B) supplémentaire.

5. Module d'alimentation électrique selon la revendication 4, dans lequel le module d'alimentation électrique (45B) supplémentaire comprend le châssis (41) et le panneau avant (20, 25, 40) et à la fois le module d'alimentation électrique (45A) et le module d'alimentation électrique supplémentaire sont formés avec les une ou plusieurs surfaces inclinées (24, 52) pour définir ensemble la voie de passage (62) à travers laquelle l'air de refroidissement peut s'écouler.

6. Module d'alimentation électrique selon la revendication 1, dans lequel l'air de refroidissement est introduit à travers les une ou plusieurs ouvertures d'écoulement d'air enfoncées (39, 54) et à travers la pluralité d'ouvertures d'écoulement d'air non enfoncées (48) et sort par une ouverture prévue au niveau d'une région arrière du châssis (41).

7. Module d'alimentation électrique selon la revendication 1, qui est un bâti monté, dans lequel les une ou plusieurs ouvertures d'écoulement d'air enfoncées (39, 54) sont assurées de demeurer non bloquées par le bâti sur lequel le module d'alimentation électrique est monté ou part n'importe quel autre dispositif (43, 46) monté sur le bâti.

8. Module d'alimentation électrique selon la revendication 7, dans lequel le panneau avant (20, 25, 40) est également formé avec une surface inclinée supplémentaire en section transversale horizontale qui s'étend à partir d'une interface supplémentaire du châssis (41) et du panneau avant qui est adjacent à une console latérale (46) pour monter le module d'alimentation électrique sur le bâti sur un bord avant de l'élément avant orienté verticalement (21) du panneau avant qui est latéralement espacé de ladite interface supplémentaire,
dans lequel ladite surface inclinée supplémentaire est formée avec une rainure qui est en communication avec une ou plusieurs ouvertures d'écoulement d'air qui sont enfoncées par rapport à ladite surface inclinée supplémentaire afin de faciliter l'entrée d'air latéralement dans l'intérieur du châssis.

9. Module d'alimentation électrique selon la revendication 1, dans lequel le panneau avant (20, 25, 40) est couplé avec le châssis (41).

10. Module d'alimentation électrique selon la revendication 1, dans lequel le panneau avant (20, 25, 40) est formé de manière solidaire avec le châssis (41).

11. Module d'alimentation électrique selon la revendication 1, dans lequel la surface supplémentaire (37) est allongée.

12. Module d'alimentation électrique selon la revendication 1, comprenant en outre un élément de filtre prévu avec le panneau avant (20, 25, 40) pour empêcher l'infiltration de contaminants à travers une ou plusieurs des ouvertures d'écoulement d'air enfoncées orientées vers le haut (39), des ouvertures d'écoulement d'air enfoncées orientées vers le bas (54) et des ouvertures d'écoulement d'air non enfoncées (48).
